# EUROPEAN PATENT APPLICATION

(11) **EP 2 131 401 A1**
(43) Date of publication of application: **09.12.2009**
(21) Application number: 08711004.5
(22) Date of filing: 08.02.2008
(51) Int. Cl.: H01L 31/04

(54) **PHOTOELECTRIC CONVERSION DEVICE AND METHOD FOR MANUFACTURING THE SAME**

(30) Priority: 29.03.2007 JP 2007088753
(71) Applicant: Mitsubishi Heavy Industries, Ltd., Tokyo 108-8215 (JP)
(72) Inventor: KOBAYASHI, Yasuyuki, Yokohama-shi Kanagawa 236-8515 (JP); SAKAI, Satoshi, Yokohama-shi Kanagawa 236-8515 (JP); YAMAGUCHI, Kengo, Nagasaki-shi Nagasaki 851-0392 (JP); ASAHARA, Yuji, Yokohama-shi Kanagawa 236-8515 (JP); GOYA, Saneyuki, Yokohama-shi Kanagawa 236-8515 (JP)
(74) Representative: Bongiovanni, Simone
(86) International application number: PCT/JP2008/052125
(87) International publication number: WO 2008/120498

(57) **Abstract**

A photovoltaic device and a process for producing the device that enable a higher level of performance to be achieved at low cost. The photovoltaic device 90 includes at least two laminated photovoltaic layers, and an intermediate layer 93 that is disposed between the two photovoltaic layers and connects the two photovoltaic layers electrically and optically, wherein the surface of the intermediate layer 93 has a plasma-resistant protective layer 93A.

## Description

### Technical Field

The present invention relates to a photovoltaic device and a process for producing the same.

### Background Art

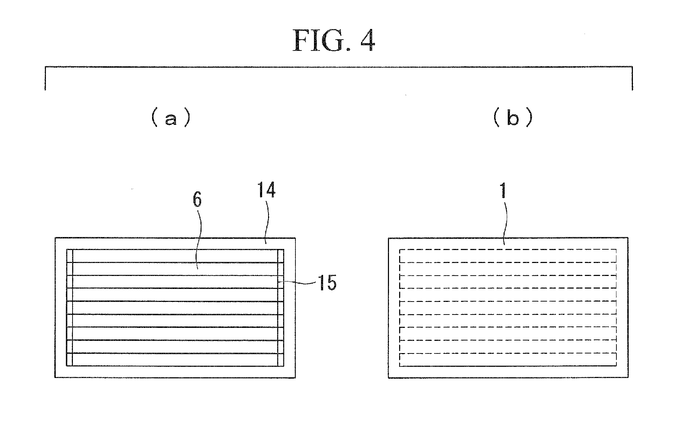

Thin-film solar cells have undergone a variety of innovations, from both the voltage and electrical current perspectives, aimed at improving the electric power output. In particular, laminated (tandem) structures have been proposed in order to enable a more efficient absorption of the incident light and subsequent conversion to an electrical current, thereby increasing the open-circuit voltage. Moreover, in order to increase the electrical current from the photovoltaic layer at the light-incident side (the upper surface) of the cell, publications such as the non-patent citation 1 have proposed the use of a transparent conductive film structure (or intermediate reflective layer, abbreviated as "intermediate layer") of optimized film thickness, which is disposed between an upper amorphous silicon photovoltaic layer and a lower polycrystalline thin-film photovoltaic layer.
Patent Citation 1: Japanese Unexamined Patent Application, Publication No. 2001-308354
Patent Citation 2: Japanese Unexamined Patent Application, Publication No. 2002-118273
Non Patent Citation 1: Report from Neuchatel University, Switzerland (pp. 728 to 731) at the 2nd World Conference and Exhibition on Photovoltaic Solar Energy Conversion, 1998, Vienna, Austria
Non Patent Citation 2: Tadatsugu Minami, Ceramics Japan, Vol. 42, No. 1 (2007), "Advantages and Problems of ZnO-based Substitute Materials", FIG. 4.

### Disclosure of Invention

However, the intermediate layer must optimize the light wavelength band reflected onto the upper photovoltaic layer, and must also increase the electrical current of the upper photovoltaic layer, and for example, although the patent citation 1 discloses a technique for improving the reflected light selectivity by providing a plurality of intermediate layers, the resulting increases in cost do not justify the level of increase in the electrical current.

Furthermore, another problem arises in that if, as described in the patent citation 2, an intermediate layer is introduced and a modularization is then performed to form series-connected circuits, then it is known that the intermediate layer acts as a current leakage pathway, causing a deterioration in the module properties. In the patent citation 2, although this phenomenon is suppressed by optimizing the electrical conductivity of the intermediate layer, there is a limit to how effectively the degradation can be suppressed.

The present invention has been developed in light of the above circumstances, and has an object of providing a photovoltaic device and a process for producing the device that enable a higher level of performance to be achieved at low cost.

As a result of conducting intensive investigations aimed at achieving the above object, the inventors of the present invention discovered that following formation of an intermediate layer after formation of the upper photovoltaic layer, the effect of the process for forming a lower photovoltaic layer using a plasma enhanced CVD film deposition apparatus (for example, hydrogen plasma exposure) causes a surface layer that increases light absorption to be formed on the surface of the intermediate layer that contacts the lower photovoltaic layer. Furthermore, they also discovered that this surface layer that increases light absorption is a degenerated layer formed by hydrogen reduction of the ZnO-based material such as Ga-doped ZnO (GZO) that is used as the material for the intermediate layer. This phenomenon causes light absorption loss at the intermediate layer, resulting in a reduction in the electric power generated by the entire solar cell.
The inventors discovered that by forming a thin coating of SiO₂, which exhibits a high degree of plasma resistance, as a protective layer on the surface of the intermediate layer, the degeneration of the intermediate layer surface could be prevented. SiO₂ usually exhibits a high degree of electrical insulation, but, as a result of research, the inventors discovered that by performing sputtering with an Ar/O₂ gas composition against a SiC target, a layer of SiO₂₋ₓC_{y} (wherein x and y are small values, hereafter this material is abbreviated as simply SiO₂) could be obtained that exhibited conductivity and was also optically transparent.
Furthermore, ZnO exhibits a property wherein a reduction in the film thickness causes an increase in the resistivity, and the inventors discovered that by using the technique described above, the film thickness of the intermediate layer could be reduced to increase the resistance of the intermediate layer, and that as a result of the reduced electrical conductivity within the in-plane direction, the current leakage pathway could be restricted.
The above technique possesses a more powerful current leakage preventative action than that of the patent citation 2, and also prevents plasma-induced degeneration of the intermediate layer, for which the patent citation 2 offers no countermeasures.

Furthermore, the inventors found that increasing the resistance of the intermediate layer was also effective in preventing the current leakage that occurs via the intermediate layer in a thin-film tandem solar cell having an intermediate layer. However in the patent citation 2, although attempts were made to increase the resistance of the Ga-doped ZnO (GZO) of the intermediate layer material by adjusting the quantity of Ga doping or increasing the oxygen concentration, there was a limit to the size of the increase in resistance. FIG. 4 in the non-patent citation 2 shows that as the ZnO film thickness is reduced, the ZnO resistivity also decreases. This is because as the film thickness is reduced, the particle size of the ZnO crystal grains that constitute the thin film decreases. Accordingly, in order to prevent current leakage through the intermediate layer, the film thickness of the ZnO film should be reduced as far as possible. However, in order to increase the selective reflectance of light of a specific wavelength, thereby increasing the electrical current from the light-incident side (the upper) photovoltaic layer, which represents the role of the intermediate layer, a ZnO film of a predetermined thickness is required.
Accordingly, in order to achieve a film thickness that exhibits the desired optical properties while maintaining a thin ZnO film, a laminated ZnO thin-film structure represented by ZnO/SiO₂/ZnO may be adopted. By adopting such a structure, the film thickness of the conductive ZnO films can be kept thin, enabling a high resistivity to be obtained, whereas the presence of the SiO₂ means that an increase in the selective reflectance of light of the specified wavelength can also be achieved.

Moreover, if a laminated structure with a total of 5 layers represented by ZnO/SiO₂/ZnO/SiO₂/ZnO is adopted in order to achieve a film thickness that exhibits the desired optical properties while maintaining a thin ZnO film, then the film thickness of the conductive ZnO films can be kept thin, enabling a high resistivity to be obtained, and an even superior increase in the selective reflectance of light of the specified wavelength can be achieved.
Furthermore, by adopting a laminated structure with a total of 4 layers including a protective layer, as represented by ZnO/SiO₂/ZnO/SiO₂, the film thickness of the conductive ZnO films can be kept thin, enabling a high resistivity to be obtained, and formation of a light absorption layer due to plasma exposure can be prevented.

In other words, in order to achieve the object described above, the present invention adopts the aspects described below.
A first aspect of the present invention provides a photovoltaic device comprising at least two laminated photovoltaic layers, and an intermediate layer that is disposed between the two photovoltaic layers and connects the two photovoltaic layers electrically and optically, wherein the surface of the intermediate layer has a plasma-resistant protective layer.

In the photovoltaic device according to the first aspect, the plasma-resistant protective layer may comprise mainly SiO₂.
Furthermore, in the photovoltaic device according to the first aspect, the plasma-resistant protective layer may be a layer comprising Si, O and C, in which the proportion of O is not less than 20% and not more than 60%, and the proportion of C is not less than 5% and not more than 30%.

In the photovoltaic device according to the first aspect, the plasma-resistant protective layer may have a film thickness of not less than 2 nm and not more than 30 nm.

A second aspect of the present invention provides a process for producing a photovoltaic device comprising at least two laminated photovoltaic layers, and an intermediate layer that is disposed between the two photovoltaic layers, and connects the two photovoltaic layers electrically and optically, the process comprising forming a plasma-resistant protective layer on the surface of the intermediate layer by performing sputtering with an Ar/O₂ gas composition.

A third aspect of the present invention provides a photovoltaic device comprising at least two laminated photovoltaic layers, and an intermediate layer that is disposed between the two photovoltaic layers and connects the two photovoltaic layers electrically and optically, wherein the intermediate layer has a laminated structure with a total of 3 layers represented by transparent conductive film / transparent film / transparent conductive film.

In the photovoltaic device according to the third aspect, the transparent conductive films may be formed using a material that comprises ZnO.

In the photovoltaic device according to the third aspect, the transparent film may be a layer comprising mainly SiO₂.
Furthermore, in the photovoltaic device according to the third aspect, the transparent film may be a layer comprising Si, O and C, in which the proportion of O is not less than 20% and not more than 60%, and the proportion of C is not less than 5% and not more than 30%.

In the photovoltaic device according to the third aspect, the transparent conductive films may have a film thickness of not less than 5 nm and not more than 100 nm.

In the photovoltaic device according to the third aspect, the transparent film may have a film thickness of not less than 2 nm and not more than 30 nm.

A fourth aspect of the present invention provides a process for producing a photovoltaic device comprising at least two laminated photovoltaic layers, and an intermediate layer that is disposed between the two photovoltaic layers and connects the two photovoltaic layers electrically and optically, wherein the intermediate layer has a laminated structure with a total of 3 layers represented by transparent conductive film / transparent film / transparent conductive film, and the transparent film is formed by performing sputtering with an Ar/O₂ gas composition.

A fifth aspect of the present invention provides a photovoltaic device comprising at least two laminated photovoltaic layers, and an intermediate layer that is disposed between the two photovoltaic layers and connects the two photovoltaic layers electrically and optically, wherein the intermediate layer has a laminated structure with a total of 5 layers represented by transparent conductive film / transparent film / transparent conductive film / transparent film / transparent conductive film.

In the photovoltaic device according to the fifth aspect, the transparent conductive films may be formed using a material that comprises ZnO.

In the photovoltaic device according to the fifth aspect, the transparent films may be layers comprising mainly SiO₂.
Furthermore, in the photovoltaic device according to the fifth aspect, the transparent films may be layers comprising Si, O and C, in which the proportion of O is not less than 20% and not more than 60%, and the proportion of C is not less than 5% and not more than 30%.

In the photovoltaic device according to the fifth aspect, the transparent conductive films may have a film thickness of not less than 5 nm and not more than 100 nm.

In the photovoltaic device according to the fifth aspect, the transparent films may have a film thickness of not less than 2 nm and not more than 30 nm.

A sixth aspect of the present invention provides a process for producing a photovoltaic device comprising at least two laminated photovoltaic layers, and an intermediate layer that is disposed between the two photovoltaic layers and connects the two photovoltaic layers electrically and optically, wherein the intermediate layer has a laminated structure with a total of 5 layers represented by transparent conductive film / transparent film / transparent conductive film / transparent film / transparent conductive film, and the transparent films are formed by performing sputtering with an Ar/O₂ gas composition.

A seventh aspect of the present invention provides a photovoltaic device comprising at least two laminated photovoltaic layers, and an intermediate layer that is disposed between the two photovoltaic layers and connects the two photovoltaic layers electrically and optically, wherein the intermediate layer has a laminated structure with a total of 4 layers represented by transparent conductive film / transparent film / transparent conductive film / transparent film.

In the photovoltaic device according to the seventh aspect, the transparent conductive films may be formed using a material that comprises ZnO.

In the photovoltaic device according to the seventh aspect, the transparent films may be plasma-resistant protective layers comprising mainly SiO₂.
Furthermore, in the photovoltaic device according to the seventh aspect, the transparent films may be plasma-resistant protective layers comprising Si, O and C, in which the proportion of O is not less than 20% and not more than 60%, and the proportion of C is not less than 5% and not more than 30%.

In the photovoltaic device according to the seventh aspect, the transparent conductive films may have a film thickness of not less than 5 nm and not more than 100 nm.

In the photovoltaic device according to the seventh aspect, the transparent films may have a film thickness of not less than 2 nm and not more than 30 nm.

An eighth aspect of the present invention provides a process for producing a photovoltaic device comprising at least two laminated photovoltaic layers, and an intermediate layer that is disposed between the two photovoltaic layers and connects the two photovoltaic layers electrically and optically, wherein the intermediate layer has a laminated structure with a total of 4 layers represented by transparent conductive film / transparent film / transparent conductive film / transparent film, and the transparent films are formed by performing sputtering with an Ar/O₂ gas composition.

According to the photovoltaic device and production process of the present invention, the selective reflectance of light of a specific wavelength provided by the intermediate layer is increased, while current leakage through the intermediate layer caused by modularization can be prevented. As a result, a high level of performance can be achieved at low cost.

### Brief Description of Drawings

[FIG. 1] A schematic view showing the structure of a photovoltaic device according to a first embodiment of the present invention.
[FIG. 2] A schematic view showing a portion of a process for producing the photovoltaic device.
[FIG. 3] A schematic view showing a portion of a process for producing the photovoltaic device.
[FIG. 4] A schematic view showing a portion of a process for producing the photovoltaic device.
[FIG. 5] A schematic view showing a portion of a process for producing the photovoltaic device.
[FIG. 6] A schematic view showing the structure of a photovoltaic device according to a second embodiment of the present invention.
[FIG. 7] A schematic view showing the structure of a photovoltaic device according to a third embodiment of the present invention.
[FIG. 8] A schematic view showing the structure of a photovoltaic device according to a fourth embodiment of the present invention.

### Explanation of Reference:

- 50:: Solar cell panel
- 90:: Photovoltaic device
- 91:: First cell layer
- 92:: Second cell layer
- 93:: Intermediate layer
- 93A:: Plasma-resistant protective layer
- 101:: Substrate
- 102:: Transparent electrode layer
- 103:: Photovoltaic layer
- 104:: Back electrode layer
- 190:: Photovoltaic device
- 191:: First cell layer
- 192:: Second cell layer
- 193:: Intermediate layer
- 193A:: Transparent conductive film
- 193B:: Transparent film
- 193C:: Transparent conductive film
- 201:: Substrate
- 202:: Transparent electrode layer
- 203:: Photovoltaic layer
- 204:: Back electrode layer
- 290:: Photovoltaic device
- 291:: First cell layer
- 292:: Second cell layer
- 293:: Intermediate layer
- 293A:: Transparent conductive film
- 293B:: Transparent film
- 293C:: Transparent conductive film
- 293D:: Transparent film
- 293E:: Transparent conductive film
- 301:: Substrate
- 302:: Transparent electrode layer
- 303:: Photovoltaic layer
- 304:: Back electrode layer
- 390:: Photovoltaic device
- 391:: First cell layer
- 392:: Second cell layer
- 393:: Intermediate layer
- 393A:: Transparent film
- 393B:: Transparent conductive film
- 393C:: Transparent film
- 393D:: Transparent conductive film

### Best Mode for Carrying Out the Invention

A first embodiment of the present invention is described below with reference to the drawings.

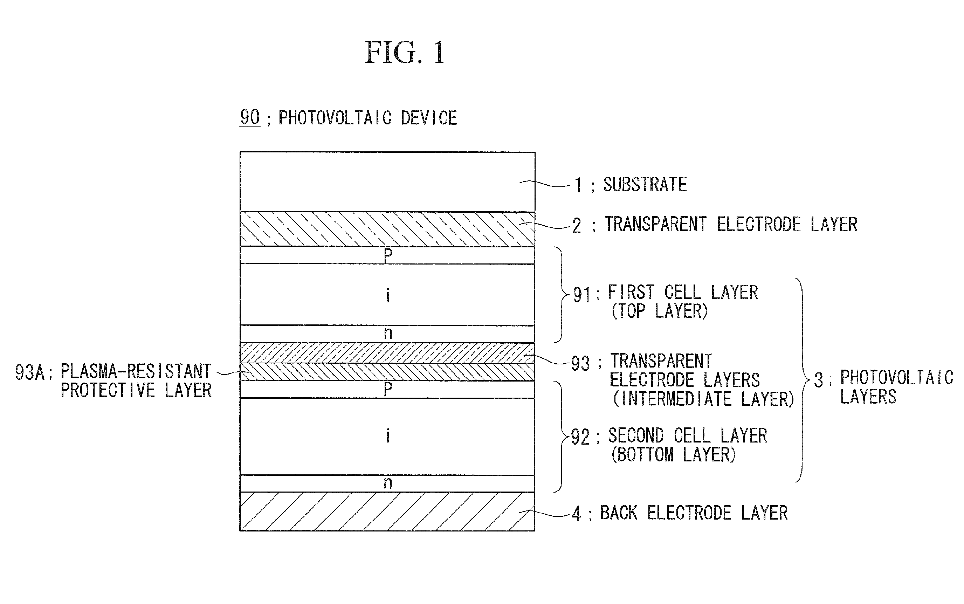

FIG. 1 is a schematic view showing the structure of a photovoltaic device according to this embodiment. The photovoltaic device 90 is a silicon-based solar cell, and comprises a substrate 1, a transparent electrode layer 2, a solar cell photovoltaic layer 3 comprising a first cell layer (a second photovoltaic layer) 91 and a second cell layer (a first photovoltaic layer) 92, and a back electrode layer 4. In this embodiment, the first cell layer 91 is an amorphous silicon-based photovoltaic layer, and the second cell layer 92 is a crystalline silicon-based photovoltaic layer.
In this description, the term "silicon-based" is a generic term that includes silicon (Si), silicon carbide (SiC) and silicon-germanium (SiGe). Furthermore, the term "crystalline silicon-based" describes a silicon system other than an amorphous silicon system, namely other than a non-crystalline silicon system, and includes both microcrystalline silicon and polycrystalline silicon systems.

An intermediate layer 93 formed from a transparent conductive film is provided between the first cell layer 91 and the second cell layer 92. A plasma-resistant protective layer 93A comprising SiO₂₋ₓC_{y} is provided on the bottom surface of the intermediate layer 93.

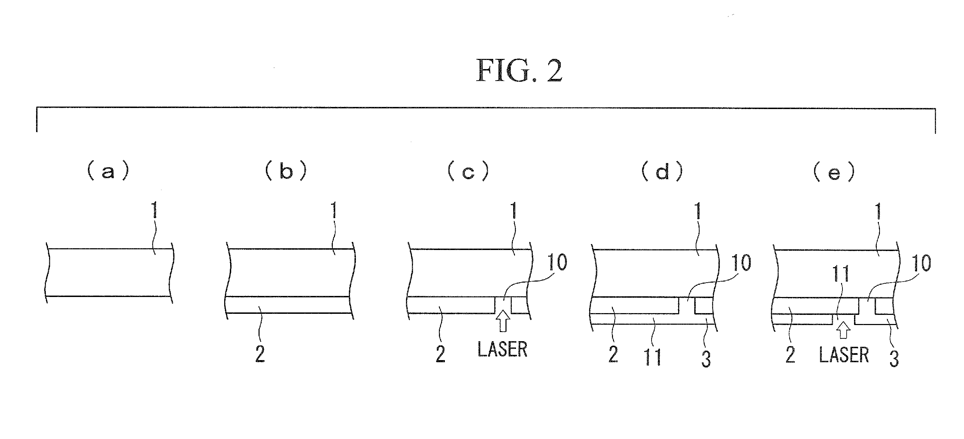

Next is a description of a process for producing a solar cell panel according to this embodiment. The description presents an example in which an amorphous silicon-based photovoltaic layer and a crystalline silicon-based photovoltaic layer are deposited sequentially, as solar cell photovoltaic layers 3, on top of a glass substrate that functions as a substrate 1. FIG. 2 through FIG. 5 are schematic views showing the process for producing a solar cell panel according to this embodiment.

### (1) FIG. 2(a)

A soda float glass substrate (1.4 m × 1.1 m × thickness: 4 mm) is used as the substrate 1. The edges of the substrate are preferably subjected to corner chamfering or R-face chamfering to prevent damage.

### (2) FIG. 2(b)

Based on the embodiment described above, a transparent electrode layer 2 is deposited on top of the substrate 1, thereby forming a transparent electrode-bearing substrate. In addition to the transparent electrode film, the transparent electrode layer 2 may also include an alkali barrier film (not shown in the figure) that is formed between the substrate 1 and the transparent electrode film. The alkali barrier film is formed by using a heated CVD apparatus to deposit a silicon oxide film (SiO₂) of not less than 50 nm and not more than 150 nm at a temperature of approximately 500°C.

### (3) FIG. 2(c)

Subsequently, the substrate 1 is mounted on an X-Y table, and the first harmonic of a YAG laser (1064 nm) is irradiated onto the film surface of the transparent electrode film, as shown by the arrow in the figure. The laser power is adjusted to ensure an appropriate process speed, and the transparent electrode film is then moved in a direction perpendicular to the direction of the series connection of the electric power generation cells, thereby causing a relative movement between the substrate 1 and the laser light, and performing laser etching across a strip with a width of not less than approximately 6 mm and not more than 10 mm, thereby forming a slot 10.

### (4) FIG. 2(d)

Using a plasma enhanced CVD apparatus under conditions including a reduced pressure atmosphere of not less than 30 Pa and not more than 150 Pa and a substrate temperature of approximately 200°C, a p-layer, i-layer and n-layer, each formed from a thin film of amorphous silicon, are deposited sequentially as the first cell layer (the top layer ) 91 of a photovoltaic layer 3. The first cell layer 91 is deposited on top of the transparent electrode layer 2 using SiH₄ gas and H₂ gas as the main raw materials. The p-layer, i-layer and n-layer are deposited in this order, with the p-layer closest to the surface from which incident sunlight enters.
In this embodiment, the p-layer of the first cell layer 91 is preferably an amorphous B-doped SiC film generated by reaction of SiH₄, H₂, CH₄ and B₂H₆ gas using an RF plasma, and the film thickness is preferably not less than 4 nm and not more than 16 nm. The i-layer of the first cell layer 91 is preferably an amorphous Si film generated by reaction of SiH₄ and H₂ using an RF plasma, and the film thickness is preferably not less than 100 nm and not more than 400 nm. The n-layer of the first cell layer 91 is preferably a Si film containing a crystalline component, generated by reaction of SiH₄, H₂, and PH₃ gas using an RF plasma, wherein the Raman ratio of the lone n-layer film is not less than 2, and the film thickness is preferably not less than 10 nm and not more than 80 nm. The "Raman ratio" refers to the ratio, determined by Raman spectroscopic evaluation, between the crystalline Si intensity at 520 cm⁻¹ and the a-Si intensity at 480 cm⁻¹ (crystalline Si intensity / a-Si intensity) (this definition also applies below). Furthermore, in order to improve the interface properties, a buffer layer (not shown in the figure) may also be provided between the p-layer film and the i-layer film.

Next, using a plasma enhanced CVD apparatus under conditions including a reduced pressure atmosphere of not more than 300 Pa, a substrate temperature of approximately 200°C, and a plasma generation frequency of not less than 40 MHz and not more than 100 MHz, a microcrystalline p-layer, microcrystalline i-layer and microcrystalline n-layer, each formed from a thin film of microcrystalline silicon, are formed sequentially, as the second cell layer (the bottom layer ) 92, on top of the first cell layer 91.
In this embodiment, the p-layer of the second cell layer 92 is preferably a Si film containing a crystalline component, generated by reaction of SiH₄, H₂, and B₂H₆ gas using an RF plasma, wherein the Raman ratio of the lone p-layer film is not less than 2, and the film thickness is preferably not less than 10 nm and not more than 60 nm. The i-layer of the second cell layer 92 is preferably a Si film containing a crystalline component, generated by reaction of SiH₄ and H₂ using an RF plasma, wherein the Raman ratio when the i-layer is deposited with a film thickness of 1.5 µm is not less than 5 (8 in the case of this embodiment), and the film thickness is preferably not less than 1,000 nm and not more than 2,000 nm. The n-layer of the second cell layer 92 is preferably a Si film containing a crystalline component, generated by reaction of SiH₄, H₂, and PH₃ gas using an RF plasma, wherein the Raman ratio of the lone n-layer film is not less than 2, and the film thickness is preferably not less than 10 nm and not more than 80 nm.

During formation of the microcrystalline silicon thin films and particularly the microcrystalline i-layer by plasma enhanced CVD, the distance d between the plasma discharge electrode and the surface of the substrate 1 is preferably not less than 3 mm and not more than 10 mm. If this distance is less than 3 mm, then the precision of the various structural components within the film deposition chamber required for processing large substrates means that maintaining the distance d at a constant level becomes difficult, which increases the possibility of the electrode getting too close and making the discharge unstable. If the distance exceeds 10 mm, then achieving a satisfactory film deposition rate (of not less than 1 nm/s) becomes difficult, and the uniformity of the plasma also deteriorates, causing a deterioration in the quality of the film due to ion impact. The i-layer of the second cell layer 92 is preferably deposited under conditions including an RF frequency of not less than 40 MHz and not more than 200 MHz, a gas pressure of not less than 500 Pa and not more than 3,000 Pa, and a film deposition rate of not less than 1 nm/s and not more than 3 nm/s, and in this embodiment, film deposition is performed using an RF frequency of 60 MHz, a gas pressure of 1.6 kPa, and a film deposition rate of 2 nm/s.

With the objective of forming a semi-reflective film to achieve electrical current consistency between the first cell layer 91 and the second cell layer 92, a ZnO-based film with a film thickness of not less than 10 nm and not more than 200 nm is deposited, using a sputtering apparatus, as an intermediate layer 93. In this intermediate layer 93, the light absorption for the lone ZnO film within a wavelength range from λ = 450 nm to 1,000 nm is preferably less than 1%.

By performing sputtering with an Ar/O₂ gas composition against a SiC target, a plasma-resistant protective layer 93A is formed on the surface of the intermediate layer 93. This enables the formation of a SiO₂₋ₓC_{y} layer that is both conductive and optically transparent.
The above x and y are small values, and a favorable protective layer is obtained in those cases where the proportion of C is within a range from 5 to 30% (Si: 1, O: 2, C: 0.15 to 0.9 (x=0, y=0.15 to 0.9)).

The sputtering film deposition conditions for the plasma-resistant protective layer 93A are as shown below.
Gas pressure: 5 × 10⁻³ Torr
Gas composition: Ar + O₂
Power: 1 W/cm²
Apparatus name: DC sputter device, SiC + Si target
The film composition can be altered by altering the Ar/O₂ gas ratio. A SiO₂₋ₓC_{y} layer with a suitable C ratio can be obtained by setting the ratio of argon:oxygen to a value within a range from 50 to 1,000, and particularly from 100 to 400.

The film thickness of the plasma-resistant protective layer 93A is typically not less than 2 nm and not more than 30 nm, and particularly favorable effects are obtained when the film thickness is not less than 5 nm and not more than 20 nm. The minimum value of 2 nm is set to ensure a reliable coating and to improve the coverage, whereas from the viewpoint of conductivity, a SiO₂ layer that is overly thick can impair the electrical conduction, and consequently the maximum value is set to 30 nm.

Compared with the light absorption for a structure in which the plasma-resistant protective layer is not formed, namely a structure represented by glass / GZO / p-Si (average light absorption 0.3% for the wavelength region from 600 to 1,100 nm), the light absorption for the structure of this embodiment in the wavelength region from 600 to 1,100 nm is, on average, not more than 0.1%, meaning light absorption can be essentially eliminated.

Formation of the intermediate layer 93 may be achieved either by continuous sputter deposition, with the targets arranged in sequence for the transparent conductive film and the plasma-resistant protective layer (the transparent film) 93A, or by batch sputter deposition in which individual sputtering chambers are prepared for the transparent conductive film and the plasma-resistant protective layer (the transparent film) 93A.

### (5) FIG. 2(e)

The substrate 1 is mounted on an X-Y table, and the second harmonic of a laser diode excited YAG laser (532 nm) is irradiated onto the film surface of the photovoltaic layer 3, as shown by the arrow in the figure. With the pulse oscillation set to not less than 10 kHz and not more than 20 kHz, the laser power is adjusted so as to achieve a suitable process speed, and laser etching is performed at a target not less than approximately 100 µm and not more than 150 µm to the side of the laser etching line within the transparent electrode layer 2, thereby forming a slot 11. Provided the positions of the laser etching lines are not inverted, no particular problems arise, but in consideration of positioning tolerances, the target is preferably set to a numerical value listed above.

### (6) FIG. 3(a)

Using a sputtering apparatus, an Ag film is then deposited as the back electrode layer 4 under a reduced pressure atmosphere and at a temperature of approximately 150°C. In this embodiment, the Ag film of the back electrode layer 4 is deposited with a film thickness of not less than 150 nm, and in order to reduce the contact resistance between the n-layer and the back electrode layer 4 and improve the light reflectance, a ZnO-based film (such as a GZO (Ga-doped ZnO) film) with a film thickness of not less than 10 nm is deposited between the photovoltaic layer 3 and the back electrode layer 4 using a sputtering apparatus.

### (7) FIG. 3(b)

The substrate 1 is mounted on an X-Y table, and the second harmonic of a laser diode excited YAG laser (532 nm) is irradiated onto the substrate 1, as shown by the arrow in the figure. The laser light is absorbed by the photovoltaic layer 3, and by using the high gas vapor pressure generated at this point, the back electrode layer 4 is removed by explosive fracture. With the pulse oscillation set to not less than 1 kHz and not more than 10 kHz, the laser power is adjusted so as to achieve a suitable process speed, and laser etching is performed at a target not less than approximately 250 µm and not more than 400 µm to the side of the laser etching line within the transparent electrode layer 2, thereby forming a slot 12. Provided the positions of the laser etching lines are not inverted, no particular problems arise, but in consideration of positioning tolerances, the target is preferably set to a numerical value listed above.

### (8) FIG. 3(c)

The electric power generation regions are compartmentalized, by using laser etching to remove the effect wherein the serially connected portions at the film edges near the edges of the substrate are prone to short circuits. The substrate 1 is mounted on an X-Y table, and the second harmonic of a laser diode excited YAG laser (532 nm) is irradiated onto the substrate 1. The laser light is absorbed by the transparent electrode layer 2 and the photovoltaic layer 3, and by using the high gas vapor pressure generated at this point, the back electrode layer 4 is removed by explosive fracture, meaning the back electrode layer 4, the photovoltaic layer 3 and the transparent electrode layer 2 are removed. With the pulse oscillation set to not less than 1 kHz and not more than 10 kHz, the laser power is adjusted so as to achieve a suitable process speed, and laser etching is conducted at a point not less than approximately 5 mm and not more than 15 mm from the edge of the substrate 1, thereby forming an X-direction insulation slot 15. A Y-direction insulation slot need not be provided at this point, because a film surface polishing and removal treatment is performed on the peripheral regions of the substrate 1 in a later step.
Performing the etching at a position not less than approximately 5 mm and not more than 10 mm from the edge of the substrate 1 is preferred, as it ensures that the insulation slot 15 is effective in inhibiting external moisture from entering the interior of the solar cell module 6 via the edges of the solar cell panel.

### (9) FIG. 4(a)

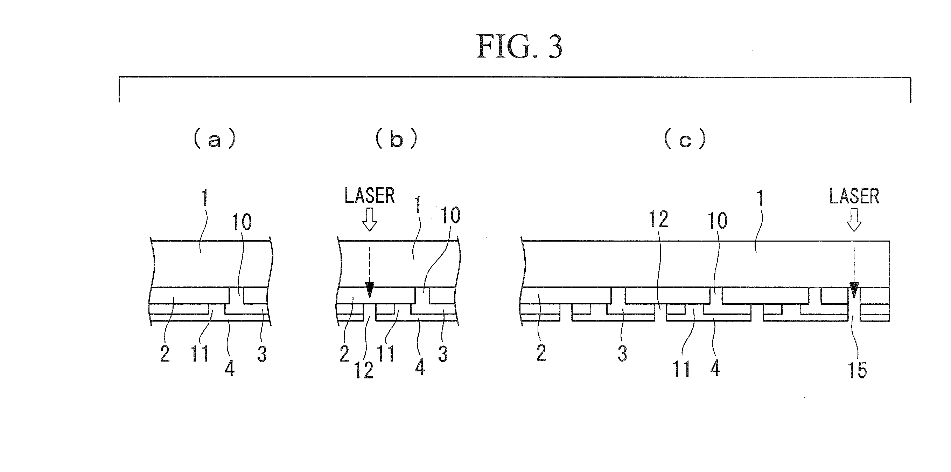

In order to ensure favorable adhesion and sealing of a backing sheet via EVA or the like in a subsequent step, the deposited films around the periphery of the substrate 1 (in a peripheral region 14) are removed, as they tend to be uneven and prone to peeling. First, grinding or blast polishing or the like is used to remove the back electrode layer 4, the photovoltaic layer 3, and the transparent electrode layer 2 from a region that is not less than 5 mm and not more than 15 mm from the edge of the substrate, and is closer to the substrate edge than the insulation slot 15 provided in the step of FIG. 3(c) described above. Grinding debris or abrasive grains are removed by washing the substrate 1.

### (10) FIG. 4(b)

A terminal box attachment portion is prepared by providing an open through-window in the backing sheet and exposing a collecting plate. A plurality of layers of an insulating material are provided in the open through-window portion in order to prevent external moisture and the like entering the solar cell.
Processing is conducted so as to enable current collection, using a copper foil, from the series-connected solar cell electric power generation cell at one end and the solar cell electric power generation cell at the other end, and to enable electric power to be extracted from a terminal box portion on the rear surface of the solar cell panel. In order to prevent short circuits between the copper foil and the various portions, an insulating sheet that is wider than the width of the copper foil is provided.
Following arrangement of the collecting copper foil and the like at predetermined positions, a sheet of a filling material such as EVA (ethylene-vinyl acetate copolymer) is arranged so as to cover the entire solar cell module 6, but not protrude beyond the substrate 1.
A backing sheet 21 with a superior waterproofing effect is positioned on top of the EVA. In this embodiment, in order to achieve a superior waterproofing and moisture-proofing effect, the backing sheet 21 is formed with a three-layer structure comprising a PTE sheet, Al foil, and a PET sheet.
The structure comprising the components up to and including the backing sheet 21 arranged in predetermined positions is subjected to internal degassing under a reduced pressure atmosphere and pressing at not less than approximately 150°C and not more than 160°C using a laminator, thereby causing cross-linking of the EVA that tightly seals the structure.

### (11) FIG. 5(a)

A terminal box is attached to the rear surface 24 of the solar cell module 6 using an adhesive.

### (12) FIG. 5(b)

The copper foil and an output cable 23 from the terminal box are connected using solder or the like, and the interior of the terminal box is filled and sealed with a sealant (a potting material). This completes the production of the solar cell panel 50.

### (13) FIG. 5(c)

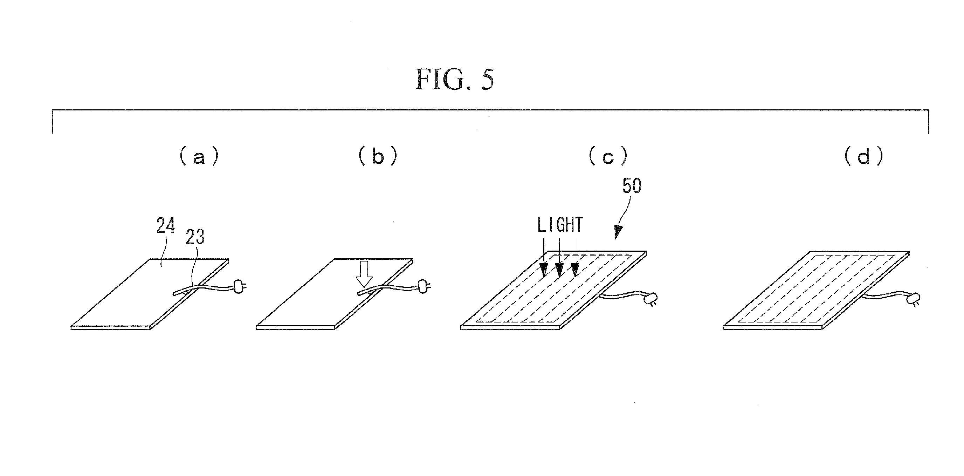

The solar cell panel 50 formed via the steps up to and including FIG. 5(b) is then subjected to an electric power generation test, as well as other tests for evaluating specific performance factors. The electric power generation test is conducted using a solar simulator that emits a standard sunlight of AM 1.5 (1,000 W/m²).

### (14) FIG. 5(d)

In tandem with the electric power generation test (FIG. 5(c)), a variety of specific performance factors including the external appearance are evaluated.

As described above, in the photovoltaic device 90 of this embodiment, by depositing a thin coating of highly plasma-resistant SiO₂ as a plasma-resistant protective layer 93A on the surface of the intermediate layer 93, degradation of the intermediate layer surface can be prevented, meaning light absorption loss at the intermediate layer 93 can be inhibited. Accordingly, a photovoltaic device 90 with a high level of performance can be obtained at low cost.

A second embodiment of the present invention is described below with reference to the drawings.

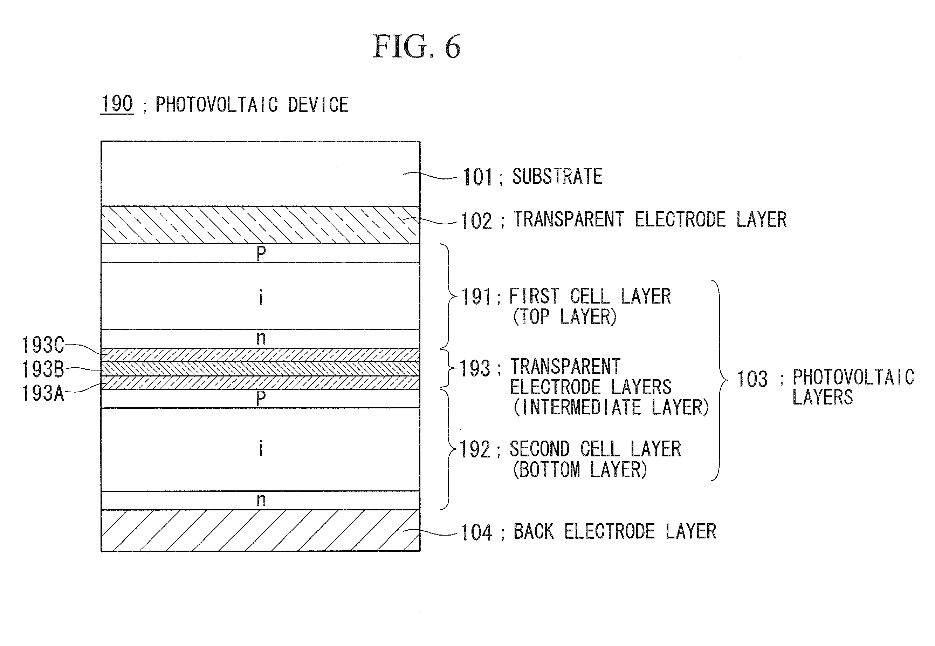

FIG. 6 is a schematic view showing the structure of a photovoltaic device according to this embodiment. The photovoltaic device 190 is a silicon-based solar cell, and comprises a substrate 101, a transparent electrode layer 102, a solar cell photovoltaic layer 103 comprising a first cell layer (a second photovoltaic layer) 191 and a second cell layer (a first photovoltaic layer) 192, and a back electrode layer 104. In this embodiment, the first cell layer 191 is an amorphous silicon-based photovoltaic layer, and the second cell layer 192 is a crystalline silicon-based photovoltaic layer.
In this description, the term "silicon-based" is a generic term that includes silicon (Si), silicon carbide (SiC) and silicon-germanium (SiGe). Furthermore, the term "crystalline silicon-based" describes a silicon system other than an amorphous silicon system, namely other than a non-crystalline silicon system, and includes both microcrystalline silicon and polycrystalline silicon systems.

An intermediate layer 193 is provided between the first cell layer 191 and the second cell layer 192. The intermediate layer 193 is formed from a total of three layers, namely a transparent conductive film 193A, a transparent film 193B, and a transparent conductive film 193C. The transparent film 193B is a layer composed of SiO₂₋ₓC_{y}.

In the description of a process for producing a solar cell panel of this embodiment, detailed descriptions are omitted for those steps that are common to the first embodiment.

In this embodiment, in order to form a semi-reflective film to achieve electrical current consistency between the first cell layer 191 and the second cell layer 192, ZnO-based films (such as GZO (Ga-doped ZnO)) with a film thickness of not less than 5 nm and not more than 100 nm are deposited, using a sputtering apparatus, as the transparent conductive films 193A and 193C of the intermediate layer 193. In this intermediate layer 193, the light absorption for a single ZnO film within a wavelength range from λ = 450 nm to 1,000 nm is preferably less than 1%. The transparent film 193B is formed by performing sputtering with an Ar/O₂ gas composition against a SiC target. This enables the formation of a SiO₂₋ₓC_{y} layer that is both conductive and optically transparent.
The above x and y are small values, and favorable results are obtained in those cases where the proportion of C is within a range from 5 to 30% (Si: 1, O: 2, C: 0.15 to 0.9 (x=0, y=0.15 to 0.9)).

The sputtering film deposition conditions for the transparent film 193B are as shown below.
Gas pressure: 5 × 10⁻³ Torr
Gas composition: Ar + O₂
Power: 1 W/cm²
Apparatus name: DC sputter device, SiC + Si target
The film composition can be altered by altering the Ar/O₂ gas ratio. A SiO₂₋ₓC_{y} layer with a suitable C ratio can be obtained by setting the ratio of argon:oxygen to a value within a range from 50 to 1,000, and particularly from 100 to 400.

The film thickness of the transparent film 193B is typically not less than 2 nm and not more than 30 nm, and particularly favorable effects are obtained when the film thickness is not less than 5 nm and not more than 20 nm. The minimum value of 2 nm is set to ensure a reliable coating and to improve the coverage, whereas from the viewpoint of conductivity, an SiO₂ layer that is overly thick can impair the electrical conduction, and consequently the maximum value is set to 30 nm. The film thickness dimension for the transparent conductive films 193A and 193C is not less than 5 nm and not more than 100 nm.

Compared with the light absorption for a structure in which the transparent film 193B is not formed, namely a structure represented by glass / GZO / p-Si (average light absorption 0.3% for the wavelength region from 600 to 1,100 nm), the light absorption for the structure of this embodiment in the wavelength region from 600 to 1,100 nm is, on average, not more than 0.1%, meaning light absorption can be essentially eliminated.

Formation of the intermediate layer 193 may be achieved either by continuous sputter deposition, with the targets arranged in sequence for the transparent conductive film 193C, the transparent film 193B and the transparent conductive film 193A, or by batch sputter deposition in which individual sputtering chambers are prepared for the transparent conductive films 193A and 193C and the transparent film 193B.

As described above, in the photovoltaic device 190 of this embodiment, by using an intermediate layer 193 with a laminated structure containing three layers, namely the transparent conductive film 193A, the transparent film 193B and the transparent conductive film 193C, the desired optical properties can be achieved while the transparent conductive films are kept thin, meaning a high resistivity can be obtained for the intermediate layer, current leakage via the intermediate layer can be prevented, and an increase or decrease can also be achieved in the selective reflectance of light of the specified wavelength caused by the intermediate layer. In other words, the electrical properties (a high resistance) can be improved without causing degradation of the optical properties of the intermediate layer. As a result, an intermediate layer with a resistivity equal to or exceeding the 1 × 10⁻³ Ω·cm of the aforementioned patent citation 2 can be achieved.

A third embodiment of the present invention is described below with reference to the drawings.

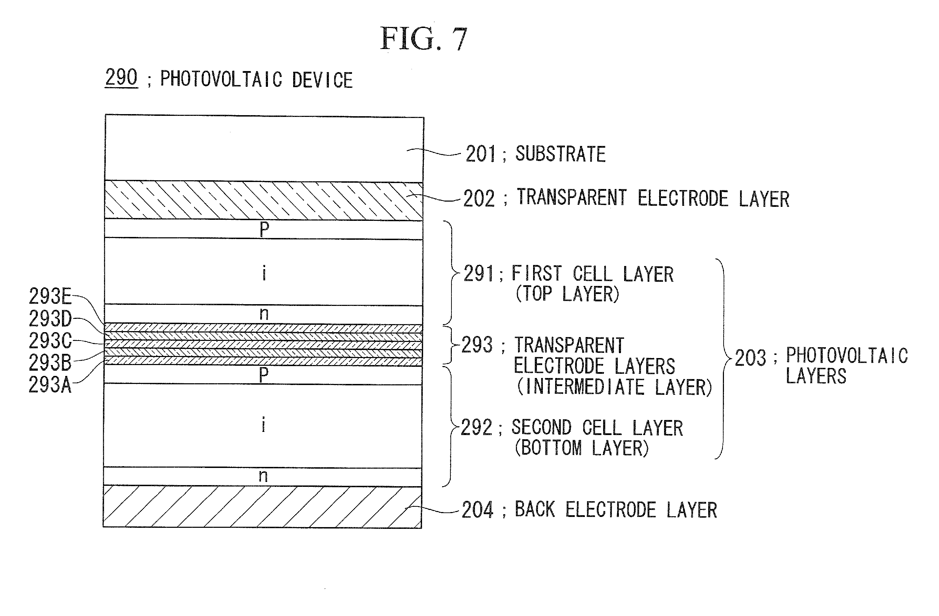

FIG. 7 is a schematic view showing the structure of a photovoltaic device according to this embodiment. The photovoltaic device 290 is a silicon-based solar cell, and comprises a substrate 201, a transparent electrode layer 202, a solar cell photovoltaic layer 203 comprising a first cell layer (a second photovoltaic layer) 291 and a second cell layer (a first photovoltaic layer) 292, and a back electrode layer 204. In this embodiment, the first cell layer 291 is an amorphous silicon-based photovoltaic layer, and the second cell layer 292 is a crystalline silicon-based photovoltaic layer.
In this description, the term "silicon-based" is a generic term that includes silicon (Si), silicon carbide (SiC) and silicon-germanium (SiGe). Furthermore, the term "crystalline silicon-based" describes a silicon system other than an amorphous silicon system, namely other than a non-crystalline silicon system, and includes both microcrystalline silicon and polycrystalline silicon systems.

An intermediate layer 293 is provided between the first cell layer 291 and the second cell layer 292. The intermediate layer 293 is formed from a total of five layers, namely a transparent conductive film 293A, a transparent film 293B, a transparent conductive film 293C, a transparent film 293D, and a transparent conductive film 293E. The transparent films 293B and 293D are layers composed of SiO₂₋ₓC_{y}.

In the description of a process for producing a solar cell panel of this embodiment, detailed descriptions are omitted for those steps that are common to the first embodiment.

In this embodiment, in order to form a semi-reflective film to achieve electrical current consistency between the first cell layer 291 and the second cell layer 292, ZnO-based films (such as GZO (Ga-doped ZnO)), each with a film thickness of not less than 5 nm and not more than 100 nm, are deposited, using a sputtering apparatus, as the transparent conductive films 293A, 293C and 293E of the intermediate layer 293. In this intermediate layer 293, the light absorption for a single ZnO film within a wavelength range from λ = 450 nm to 1,000 nm is preferably less than 1%. The transparent films 293B and 293D are formed by performing sputtering with an Ar/O₂ gas composition against a SiC target. This enables the formation of SiO₂₋ₓC_{y} layers that are both conductive and optically transparent.
The above x and y are small values, and favorable results are obtained in those cases where the proportion of C is within a range from 5 to 30% (Si: 1, O: 2, C: 0.15 to 0.9 (x=0, y=0.15 to 0.9)).

The sputtering film deposition conditions for the transparent films 293B and 293D are as shown below.
Gas pressure: 5 × 10⁻³ Torr
Gas composition: Ar + O₂
Power: 1 W/cm²
Apparatus name: DC sputter device, SiC + Si target
The film composition can be altered by altering the Ar/O₂ gas ratio. A SiO₂₋ₓC_{y} layer with a suitable C ratio can be obtained by setting the ratio of argon:oxygen to a value within a range from 50 to 1,000, and particularly from 100 to 400.

The film thickness of each of the transparent films 293B and 293D is typically not less than 2 nm and not more than 30 nm, and particularly favorable effects are obtained when the film thickness is not less than 5 nm and not more than 20 nm. The minimum value of 2 nm is set to ensure a reliable coating and to improve the coverage, whereas from the viewpoint of conductivity, an SiO₂ layer that is overly thick can impair the electrical conduction, and consequently the maximum value is set to 30 nm. The film thickness dimension for the transparent conductive films 293A, 293C and 293E is not less than 5 nm and not more than 100 nm.

Compared with the light absorption for a structure in which the transparent films 293B and 293D are not formed, namely a structure represented by glass / GZO / p-Si (average light absorption 0.3% for the wavelength region from 600 to 1,100 nm), the light absorption for the structure of this embodiment in the wavelength region from 600 to 1,100 nm is, on average, not more than 0.1%, meaning light absorption can be essentially eliminated.

Formation of the intermediate layer 293 may be achieved either by continuous sputter deposition, with the targets arranged in sequence for the transparent conductive film 293E, the transparent film 293D, the transparent conductive film 293C, the transparent film 293B and the transparent conductive film 293A, or by batch sputter deposition in which individual sputtering chambers are prepared for the transparent conductive films and the transparent films.

As described above, in the photovoltaic device 290 of this embodiment, by using an intermediate layer 293 with a laminated structure containing five layers, namely the transparent conductive film 293A, the transparent film 293B, the transparent conductive film 293C, the transparent film 293D, and the transparent conductive film 293E, a high resistivity can be obtained for the intermediate layer, current leakage via the intermediate layer can be prevented, and an increase or decrease can also be achieved in the selective reflectance of light of the specified wavelength caused by the intermediate layer. In other words, the electrical properties (a high resistance) can be improved without causing degradation of the optical properties of the intermediate layer. As a result, an intermediate layer with a resistivity equal to or exceeding the 1 × 10⁻³ Ω·cm of the aforementioned patent citation 2 can be achieved.

A fourth embodiment of the present invention is described below with reference to the drawings.

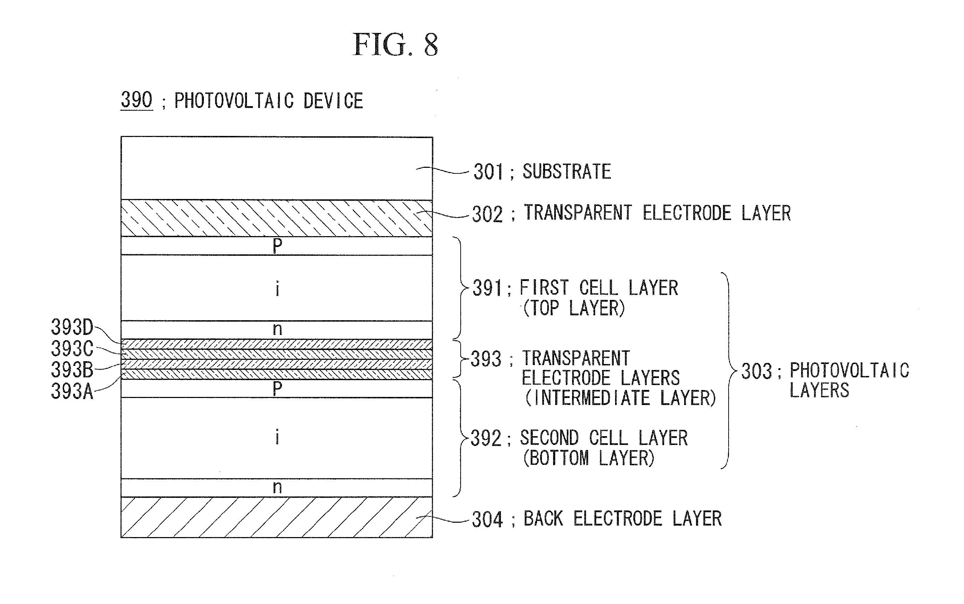

FIG. 8 is a schematic view showing the structure of a photovoltaic device according to this embodiment. The photovoltaic device 390 is a silicon-based solar cell, and comprises a substrate 301, a transparent electrode layer 302, a solar cell photovoltaic layer 303 comprising a first cell layer (a second photovoltaic layer) 391 and a second cell layer (a first photovoltaic layer) 392, and a back electrode layer 304. In this embodiment, the first cell layer 391 is an amorphous silicon-based photovoltaic layer, and the second cell layer 392 is a crystalline silicon-based photovoltaic layer.
In this description, the term "silicon-based" is a generic term that includes silicon (Si), silicon carbide (SiC) and silicon-germanium (SiGe). Furthermore, the term "crystalline silicon-based" describes a silicon system other than an amorphous silicon system, namely other than a non-crystalline silicon system, and includes both microcrystalline silicon and polycrystalline silicon systems.

An intermediate layer 393 is provided between the first cell layer 391 and the second cell layer 392. The intermediate layer 393 is formed from a total of four layers which, listed from the bottom layer upwards, are a transparent film 393A, a transparent conductive film 393B, a transparent film 393C, and a transparent conductive film 393D. The transparent films 393A and 393C are plasma-resistant protective layers composed of SiO₂₋ₓC_{y}.

In the description of a process for producing a solar cell panel of this embodiment, detailed descriptions are omitted for those steps that are common to the first embodiment.

In this embodiment, in order to form a semi-reflective film to achieve electrical current consistency between the first cell layer 391 and the second cell layer 392, ZnO-based films (such as GZO (Ga-doped ZnO)) with a film thickness of not less than 5 nm and not more than 100 nm are deposited, using a sputtering apparatus, as the transparent conductive films 393B and 393D of the intermediate layer 393. In this intermediate layer 393, the light absorption for a single ZnO film within a wavelength range from λ = 450 nm to 1,000 nm is preferably less than 1%. The transparent films 393A and 393C are formed by performing sputtering with an Ar/O₂ gas composition against a SiC target. This enables the formation of SiO₂₋ₓC_{y} layers that are both conductive and optically transparent.
The above x and y are small values, and favorable results are obtained in those cases where the proportion of C is within a range from 5 to 30% (Si: 1, O: 2, C: 0.15 to 0.9 (x=0, y=0.15 to 0.9)).

The sputtering film deposition conditions for the transparent films 393A and 393C are as shown below.
Gas pressure: 5 × 10⁻³ Torr
Gas composition: Ar + O₂
Power: 1 W/cm²
Apparatus name: DC sputter device, SiC + Si target
The film composition can be altered by altering the Ar/O₂ gas ratio. A SiO₂₋ₓC_{y} layer with a suitable C ratio can be obtained by setting the ratio of argon:oxygen to a value within a range from 50 to 1,000, and particularly from 100 to 400.

The film thickness of each of the transparent films 393A and 393C is typically not less than 2 nm and not more than 30 nm, and particularly favorable effects are obtained when the film thickness is not less than 5 nm and not more than 20 nm. The minimum value of 2 nm is set to ensure a reliable coating and to improve the coverage, whereas from the viewpoint of conductivity, an SiO₂ layer that is overly thick can impair the electrical conduction, and consequently the maximum value is set to 30 nm. The film thickness dimension for the transparent conductive films 393B and 393D is not less than 5 nm and not more than 100 nm.

Compared with the light absorption for a structure in which the transparent films 393A and 393C are not formed, namely a structure represented by glass / GZO / p-Si (average light absorption 0.3% for the wavelength region from 600 to 1,100 nm), the light absorption for the structure of this embodiment in the wavelength region from 600 to 1,100 nm is, on average, not more than 0.1%, meaning light absorption can be essentially eliminated.

Formation of the intermediate layer 393 may be achieved either by continuous sputter deposition, with the targets arranged in sequence for the transparent conductive film 393D, the transparent film 393C, the transparent conductive film 393B and the transparent film 393A, or by batch sputter deposition in which individual sputtering chambers are prepared for the transparent conductive films and the transparent films.

As described above, in the photovoltaic device 390 of this embodiment, by using an intermediate layer 393 with a laminated structure containing four layers, namely the transparent film 393A, the transparent conductive film 393B, the transparent film 393C, and the transparent conductive film 393D, in which a thin film of highly plasma-resistant SiO₂ functions as a protective layer, the desired optical properties can be achieved while the transparent conductive films are kept thin, meaning a high resistivity can be obtained for the intermediate layer, current leakage via the intermediate layer can be prevented, and an increase or decrease can also be achieved in the selective reflectance of light of the specified wavelength caused by the intermediate layer. Furthermore, the transparent films act as protective layers, meaning the transparent conductive films do not conduct the photovoltaic layer directly, and enabling the formation of a surface layer of increased light absorption to be suppressed. In other words, the electrical properties (a high resistance) can be improved without causing degradation of the optical properties of the intermediate layer. As a result, an intermediate layer with a resistivity equal to or exceeding the 1 × 10⁻³ Ω·cm of the aforementioned patent citation 2 can be achieved.

### Test Example 1

The composition of the SiO₂₋ₓC_{y} film that is a structural component in each of the above embodiments was investigated.

Samples (a) to (d) were prepared with a 3-layer laminated structure in which a SiO₂₋ₓC_{y} film (film thickness: 10 nm) with a composition shown in Table 1 was sandwiched between two layers of a GZO film (film thickness of each film: 40 nm). For each sample, the resistance in a direction perpendicular to the film surface and the optical absorption were measured. The results are also shown in Table 1. For comparison, the resistance in a direction perpendicular to the film surface for a lone GZO film (film thickness: 40 nm), which represents a conventional intermediate layer, was 6 Ω.

**Table 1**

| Sample | (a) | (b) | (c) | (d) |
|---|---|---|---|---|
| Si ratio within SiO₂₋ₓC_{y} (%) | 50 | 42 | 35 | 34 |
| O ratio within SiO₂₋ₓC_{y} (%) | 15 | 33 | 59 | 66 |
| C ratio within SiO₂₋ₓC_{y} (%) | 35 | 25 | 6 | 0 |
| Resistance in perpendicular direction (Ω) | - | 4 | 6 | 14 |
| Optical absorption | Yes | No | No | No |

Upon investigation of the properties of the prepared samples (a) to (d) it was clear that, as shown in Table 1, the sample (a) exhibited optical absorption, and could therefore not be used as an intermediate layer. Furthermore, the sample (d) had a higher resistance than the lone GZO film of the conventional example, and could therefore not be used as an intermediate layer.
Accordingly, upon consideration of the resistance of the intermediate layer in the perpendicular direction and the optical absorption, it was clear that the composition of the SiO₂₋ₓC_{y} that constitutes the intermediate layer in each of the above embodiments preferably has an oxygen composition within a range from 20 to 60%, and a carbon composition within a range from 30 to 5%.

The SiO₂₋ₓC_{y} film in these test examples was positioned in the same manner as the transparent film 193B that represents one of the structural elements in the 3-layer structure of the second embodiment, but a SiO₂₋ₓC_{y} film with the preferred composition described above can also be applied to the transparent films in other structures (such as the plasma-resistant protective layer 93A of the first embodiment, or the transparent films 293B, 293D, 393A and 393C in the multilayer structures of the third embodiment and fourth embodiment).

### Test Example 2

The film thickness dependency of the resistance of the single film of GZO that represents one of the structural elements within each of the above embodiments was investigated.

Using a set of low-temperature film deposition conditions (A) and a set of high-temperature film deposition conditions (B), samples were formed by depositing a GZO film at one of the two film thickness values shown in Table 2, and the resistivity within the in-plane direction was then measured for each sample. The results are also shown in Table 2.

**Table 2**

| Temperature conditions | (A) | | (B) | |
|---|---|---|---|---|
| Film thickness | 50 nm | 80 nm | 40 nm | 80 nm |
| Resistivity in the in-plane direction (Ωcm) | 1.3E5 | 5.5E4 | 6.7E2 | 1.8E2 |

From the results shown in Table 2 it is evident that regardless of the film deposition temperature conditions, the resistivity increases as the GZO film thickness is reduced, indicating that reducing the film thickness of the GZO film is effective in preventing current leakage via the intermediate layer.

### Modified Example 1

In the second embodiment described above, a configuration was adopted in which ZnO-based films (such as GZO films), each with a film thickness of not less than 5 nm and not more than 100 nm, were provided as the transparent conductive films 193A and 193C of the intermediate layer 193, and a SiO₂₋ₓC_{y} film with a film thickness of not less than 2 nm and not more than 30 nm, and preferably not less than 5 nm and not more than 20 nm, was provided as the transparent film 193B, but instead of this configuration, a modified configuration may be adopted in which ZnO-based films (such as GZO films) with a film thickness of not more than 10 nm are provided as the transparent conductive films 193A and 193C, and a SiO₂₋ₓC_{y} film with a film thickness of not less than 10 nm and not more than 30 nm is provided as the transparent film 193B.

In this modified example, in order to increase the resistivity within the in-plane direction by altering the structure of the lone GZO film (of thickness 50 to 100 nm) that is used as a conventional intermediate layer, instead of simply reducing the film thickness of the lone GZO film, a SiO₂₋ₓC_{y} film is inserted between two GZO layers, and the film thickness of the SiO₂₋ₓC_{y} film is adjusted so as to achieve the desired optical properties upon optical analysis. As a result, the conductivity within the in-plane direction of the GZO layer is minimal.

### Modified Example 2

In the second embodiment described above, a configuration was adopted in which ZnO-based films (such as GZO films), each with a film thickness of not less than 5 nm and not more than 100 nm, were provided as the transparent conductive films 193A and 193C of the intermediate layer 193, and a SiO₂₋ₓC_{y} film with a film thickness of not less than 2 nm and not more than 30 nm, and preferably not less than 5 nm and not more than 20 nm, was provided as the transparent film 193B, but instead of this configuration, a modified configuration may be adopted in which ZnO-based films (such as GZO films) with a film thickness of not more than 5 nm are provided as the transparent conductive films 193A and 193C, and a SiO₂₋ₓC_{y} film with a film thickness of not less than 10 nm and not more than 30 nm is provided as the transparent film 193B.

In this modified example, in order to increase the resistivity within the in-plane direction by altering the structure of the lone GZO film (of thickness 50 to 100 nm) that is used as a conventional intermediate layer, instead of simply reducing the film thickness of the lone GZO film, a SiO₂₋ₓC_{y} film is inserted between two GZO layers, and the film thickness of the SiO₂₋ₓC_{y} film is adjusted so as to achieve the desired optical properties upon optical analysis. In this modified example, the GZO films function only as contact layers for electrical conduction in a perpendicular direction.

## Claims

1. A photovoltaic device comprising at least two laminated photovoltaic layers, and
an intermediate layer that is disposed between the two photovoltaic layers and connects the two photovoltaic layers electrically and optically, wherein
a surface of the intermediate layer has a plasma-resistant protective layer.

2. The photovoltaic device according to claim 1, wherein the plasma-resistant protective layer comprises mainly SiO₂.

3. The photovoltaic device according to claim 1, wherein the plasma-resistant protective layer is a layer that comprises Si, O and C, in which a proportion of O is not less than 20% and not more than 60%, and a proportion of C is not less than 5% and not more than 30%.

4. The photovoltaic device according to any one of claims 1 through 3, wherein the plasma-resistant protective layer has a film thickness of not less than 2 nm and not more than 30 nm.

5. A process for producing a photovoltaic device comprising at least two laminated photovoltaic layers, and
an intermediate layer that is disposed between the two photovoltaic layers, and connects the two photovoltaic layers electrically and optically,
the process comprising forming a plasma-resistant protective layer on a surface of the intermediate layer by performing sputtering with an Ar/O₂ gas composition.

6. A photovoltaic device comprising at least two laminated photovoltaic layers, and
an intermediate layer that is disposed between the two photovoltaic layers and connects the two photovoltaic layers electrically and optically, wherein
the intermediate layer has a laminated structure with a total of 3 layers represented by transparent conductive film / transparent film / transparent conductive film.

7. The photovoltaic device according to claim 6, wherein the transparent conductive films are formed using a material that comprises ZnO.

8. The photovoltaic device according to either claim 6 or 7, wherein the transparent film is a layer comprising mainly SiO₂.

9. The photovoltaic device according to either claim 6 or 7, wherein the transparent film is a layer that comprises Si, O and C, in which a proportion of O is not less than 20% and not more than 60%, and a proportion of C is not less than 5% and not more than 30%.

10. The photovoltaic device according to any one of claims 6 through 9, wherein each of the transparent conductive films has a film thickness of not less than 5 nm and not more than 100 nm.

11. The photovoltaic device according to any one of claims 6 through 10, wherein the transparent film has a film thickness of not less than 2 nm and not more than 30 nm.

12. A process for producing a photovoltaic device comprising at least two laminated photovoltaic layers, and
an intermediate layer that is disposed between the two photovoltaic layers and connects the two photovoltaic layers electrically and optically, wherein
the intermediate layer has a laminated structure with a total of 3 layers represented by transparent conductive film / transparent film / transparent conductive film, and the transparent film is formed by performing sputtering with an Ar/O₂ gas composition.

13. A photovoltaic device comprising at least two laminated photovoltaic layers, and
an intermediate layer that is disposed between the two photovoltaic layers and connects the two photovoltaic layers electrically and optically, wherein
the intermediate layer has a laminated structure with a total of 5 layers represented by transparent conductive film / transparent film / transparent conductive film / transparent film / transparent conductive film.

14. The photovoltaic device according to claim 13, wherein the transparent conductive films are formed using a material that comprises ZnO.

15. The photovoltaic device according to either claim 13 or 14, wherein the transparent films are layers comprising mainly SiO₂.

16. The photovoltaic device according to either claim 13 or 14, wherein the transparent films are layers comprising Si, O and C, in which a proportion of O is not less than 20% and not more than 60%, and a proportion of C is not less than 5% and not more than 30%.

17. The photovoltaic device according to any one of claims 13 through 16, wherein each of the transparent conductive films has a film thickness of not less than 5 nm and not more than 100 nm.

18. The photovoltaic device according to any one of claims 13 through 17, wherein each of the transparent films has a film thickness of not less than 2 nm and not more than 30 nm.

19. A process for producing a photovoltaic device comprising at least two laminated photovoltaic layers, and
an intermediate layer that is disposed between the two photovoltaic layers and connects the two photovoltaic layers electrically and optically, wherein
the intermediate layer has a laminated structure with a total of 5 layers represented by transparent conductive film / transparent film / transparent conductive film / transparent film / transparent conductive film, and the transparent films are formed by performing sputtering with an Ar/O₂ gas composition.

20. A photovoltaic device comprising at least two laminated photovoltaic layers, and
an intermediate layer that is disposed between the two photovoltaic layers and connects the two photovoltaic layers electrically and optically, wherein
the intermediate layer has a laminated structure with a total of 4 layers represented by transparent conductive film / transparent film / transparent conductive film / transparent film.

21. The photovoltaic device according to claim 20, wherein each of the transparent conductive films is formed using a material that comprises ZnO.

22. The photovoltaic device according to either claim 20 or 21, wherein the transparent films are plasma-resistant protective layers comprising mainly SiO₂.

23. The photovoltaic device according to either claim 20 or 21, wherein the transparent films are plasma-resistant protective layers comprising Si, O and C, in which the proportion of O is not less than 20% and not more than 60%, and the proportion of C is not less than 5% and not more than 30%.

24. The photovoltaic device according to any one of claims 20 through 23, wherein each of the transparent conductive films has a film thickness of not less than 5 nm and not more than 100 nm.

25. The photovoltaic device according to any one of claims 20 through 24, wherein each of the transparent films has a film thickness of not less than 2 nm and not more than 30 nm.

26. A process for producing a photovoltaic device comprising at least two laminated photovoltaic layers, and
an intermediate layer that is disposed between the two photovoltaic layers and connects the two photovoltaic layers electrically and optically, wherein
the intermediate layer has a laminated structure with a total of 4 layers represented by transparent conductive film / transparent film / transparent conductive film / transparent film, and the transparent films are formed by sputtering with an Ar/O₂ gas composition.
